# FASCICULE DE BREVET EUROPEEN

(11) **EP 3 817 366 B1**
(45) Date de publication et mention de la délivrance du brevet: **14.09.2022**
(21) Numéro de dépôt: 20204157.0
(22) Date de dépôt: 27.10.2020
(51) Int. Cl.: H04N 5/341, H04N 5/32, H04N 5/378, H04N 5/365

(54) **CAPTEUR PHOTOSENSIBLE À CAPTEURS ÉLÉMENTAIRES RABOUTÉS**
LICHTEMPFINDLICHER SENSOR MIT ZUSAMMENGEFÜGTEN ELEMENTAREN SENSOREN
PHOTOSENSITIVE SENSOR WITH ELEMENTARY SENSORS JOINED END TO END

(30) Priorité: 31.10.2019 FR 1912268
(43) Date de publication de la demande: 05.05.2021
(73) Titulaire: Trixell, 38430 Moirans (FR)
(72) Inventeur: SIAUD, Martin, 38430 MOIRANS (FR); BOSSET, Bruno, 38430 MOIRANS (FR)
(74) Mandataire: Atout PI Laplace

(56) Documents cités:
- EP-A1- 2 378 258
- US-A1- 2011 147 598

## Description

La présente invention concerne un dispositif photosensible comportant une matrice de pixels photosensibles du type notamment réalisés par des techniques de dépôt de matériaux semi-conducteurs. L'invention peut être mise en œuvre pour l'imagerie de rayonnements ionisants et notamment les rayonnements X pour la détection des images radiologiques dans le domaine médical ou celui du contrôle non destructif dans le domaine industriel ou celui de la sécurité.

Les capteurs photosensibles électroniques sont réalisés sous forme de panneaux plats. Ils comprennent une matrice de circuits électroniques élémentaires c'est-à-dire de blocs de composants. Les circuits électroniques élémentaires sont arrangés en rangées et plus précisément en lignes et en colonnes pour former la matrice. Les circuits électroniques élémentaires sont aussi appelés pixels dans les capteurs d'image. Les pixels sont par exemple formés d'une zone photosensible délivrant un courant de charges électriques en fonction du flux de photons qu'elle reçoit et d'un circuit électronique de traitement de ce courant. La zone photosensible comprend un photodétecteur comme exemple une photodiode, une photorésistance ou un phototransistor. Le pixel comprend également, en plus de l'élément photosensible, un circuit électronique interne au pixel qui a une fonction de collecteur de charge, de commande ou de traitement. Ce circuit est souvent réalisé à partir de composants semi-conducteurs tel que des diodes ou des transistors et permettant de réaliser des fonctions telles que l'ouverture ou la fermeture d'un circuit, la remise à zéro du photodétecteur, l'amplification...

Les capteurs photosensibles comprennent en outre des conducteurs reliant les pixels. Ces conducteurs peuvent circuler soit en ligne pour relier les pixels ligne par ligne soit en colonne pour relier les pixels colonne par colonne. Les conducteurs de ligne et/ou de colonne assurent les polarisations nécessaires, les commandes et les voies de sortie de l'information détectée par chaque pixel. En pratique l'appellation ligne ou colonne est purement arbitraire. Ces appellations peuvent bien entendu être interverties.

Les capteurs photosensibles sont souvent réalisés au moyen de techniques de dépôts en films minces de matériaux semi-conducteurs sur un substrat à base de verre ou de silicium. Dans l'imagerie mettant en œuvre des rayonnements ionisants et notamment des rayons X, la difficulté à focaliser ce type de rayonnement conduit à réaliser des capteurs photosensibles de grandes dimensions. Les dimensions des capteurs dépassent souvent les dimensions classiques des substrats. A titre d'exemple, on trouve couramment des substrats de 200 ou 300mm de diamètre. Par contre les capteurs photosensibles sont généralement rectangulaires et leur plus grande dimension peut dépasser 400mm. Pour réaliser ces capteurs de grandes dimensions, il est connu de rabouter plusieurs substrats. Un procédé de réalisation de tels capteurs raboutés dans lequel un scintillateur permet de transposer la longueur d'onde des photons X reçus par le capteur vers la longueur d'onde à laquelle les photodétecteurs sont sensibles est par exemple décrit dans la demande de brevet WO2008/142135 A1 déposée au nom de la demanderesse. Cette demande de brevet décrit l'alignement physique de différents capteurs élémentaires, chacun réalisé sur son propre substrat. Cette demande de brevet ne s'intéresse pas aux différences électriques pouvant intervenir entre les différents capteurs élémentaires. Dans une autre demande de brevet :
WO02/41621 A2, la demanderesse s'est intéressée au réglage séparé de la polarisation des pixels des différents capteurs élémentaires. Ce réglage permet de limiter les différences de niveaux de sortie de pixels voisins lorsque ceux-ci sont saturés. Les niveaux de sortie des différents pixels peuvent en effet différer d'un capteur élémentaire à l'autre. La demande de brevet WO02/41621 A2 décrit également l'application de corrections d'offset et de gain permettant d'adapter la courbe de réponse des différents pixels et notamment lorsqu'ils appartiennent à des capteurs élémentaires différents. Ces différents réglages fonctionnent bien au niveau de la sortie de chacun des pixels et lorsque la lecture de la matrice de pixels se fait à faible vitesse. Cependant, la longueur des conducteurs de ligne peut perturber le pilotage et la lecture de la matrice de pixels. Ceci est d'autant plus pénalisant que la vitesse de pilotage et de lecture de la matrice augmente. Une autre demande de brevet US2011147598 A1 divulgue un capteur photosensible détectant les rayons X et comprenant plusieurs capteurs raboutés.
Des essais en interne ont montré que les impédances des conducteurs peuvent différer de façon importante, surtout lorsque les conducteurs appartiennent à des capteurs élémentaires distincts raboutés. Il est possible de spécifier des tolérances serrées dans les impédances des conducteurs. Ces tolérances serrées tendent à augmenter le coût de réalisation global du capteur. La demande de brevet EP2378258 A1 divulgue un P-transistor commun à un groupe de pixels photosensibles et permettant l'adaptation d'impédance de leurs sorties respectives vers la colonne.

L'invention vise à libérer les tolérances sur les valeurs des impédances des conducteurs eux-mêmes en prévoyant l'adjonction de composants spécifiques disposés en parallèle ou en série avec chaque conducteur afin d'équilibrer les impédances globales de conducteurs voisins vues de l'extérieur de la matrice.

A cet effet, l'invention a pour objet un capteur photosensible comprenant plusieurs capteurs élémentaires raboutés, chaque capteur élémentaire comprenant une matrice de pixels organisés en rangées, les pixels de chaque rangée étant reliés à des conducteurs de plusieurs types, dont des conducteurs de colonne reliés à des circuits de lecture du capteur. Le capteur photosensible comprend en outre, raccordé à chacun des conducteurs de colonne, un groupe de composants distinct du conducteur considéré, le groupe de composants formant une impédance d'adaptation du conducteur considéré. Dans chaque capteur élémentaire, les impédances ont une même valeur et pour des capteurs élémentaires différents, les impédances ont des valeurs d'impédance différentes de façon à équilibrer les impédances de liaison entre les différents circuits de lecture et les conducteurs de colonne correspondants pour les différents capteurs élémentaires.

De plus, les pixels de chaque rangée sont reliés à des conducteurs de type conducteur d'alimentation reliés à des circuits d'alimentation du capteur. Avantageusement, le capteur photosensible comprend, raccordé à chacun des conducteurs d'alimentation, un groupe de composants distinct du conducteur considéré, le groupe de composants formant une impédance d'adaptation du conducteur considéré. Dans chaque capteur élémentaire, les impédances ont une même valeur et dans des capteurs élémentaires différents, les impédances ont des valeurs d'impédance différentes de façon à équilibrer les impédances de liaison entre les différents circuits d'alimentation et les conducteurs d'alimentation correspondants pour les différents capteurs élémentaires.

De plus, les pixels de chaque rangée sont reliés à des conducteurs de type conducteur de commande reliés à des circuits de commande du capteur Avantageusement, le capteur photosensible comprend, raccordé à chacun des conducteurs de commande, un groupe de composants distinct du conducteur considéré, le groupe de composants formant une impédance d'adaptation du conducteur considéré. Dans chaque capteur élémentaire, les impédances ont une même valeur et dans des capteurs élémentaires différents, les impédances ont des valeurs d'impédance différentes de façon à équilibrer les impédances de liaison entre les différents circuits de commande et les conducteurs de commande correspondants pour les différents capteurs élémentaires.

Pour deux capteurs élémentaires distincts, les conducteurs d'au moins un type peuvent posséder des longueurs différentes et, dans ce cas, les valeurs d'impédances des groupes de composants associés aux conducteurs d'au moins un type sont adaptées en fonction de leur longueur respective.

Les groupes de composants comprennent avantageusement une résistance raccordée en série sur le conducteur considéré et une capacité raccordée entre le conducteur considéré et une masse du dispositif.

Chaque groupe de composants est avantageusement disposé sur un substrat du capteur élémentaire correspondant entre la matrice de pixels et le circuit auquel le conducteur associé est raccordé.

les capteurs élémentaires sont avantageusement formés chacun sur un substrat indépendant.

L'invention sera mieux comprise et d'autres avantages apparaîtront à la lecture de la description détaillée d'un mode de réalisation donné à titre d'exemple, description illustrée par le dessin joint dans lequel :
La figure 1 représente schématiquement un exemple de matrice de pixels 1T pouvant être mise en œuvre dans un capteur conforme à l'invention ;
La figure 2 représente schématiquement un exemple de matrice de pixels 3T pouvant être mise en œuvre dans un capteur conforme à l'invention ;
La figure 3 représente schématiquement un exemple de capteur réalisé à partir de plusieurs capteurs élémentaires raboutés ;
La figure 4 représente plus en détail une partie d'un des capteurs élémentaires.

Par souci de clarté, les mêmes éléments porteront les mêmes repères dans les différentes figures.

La description qui suit est faite en rapport avec un détecteur matriciel formé de plusieurs circuits électroniques élémentaires appelés pixels comprenant chacun un élément sensible à une grandeur physique. Les circuits électroniques élémentaires sont, dans l'exemple décrit, des pixels sensibles à un rayonnement lumineux. Il est bien entendu que l'invention peut être mise en œuvre pour d'autres détecteurs sensibles à toute forme de grandeur physique permettant par exemple de réaliser une cartographie de pression ou de température.

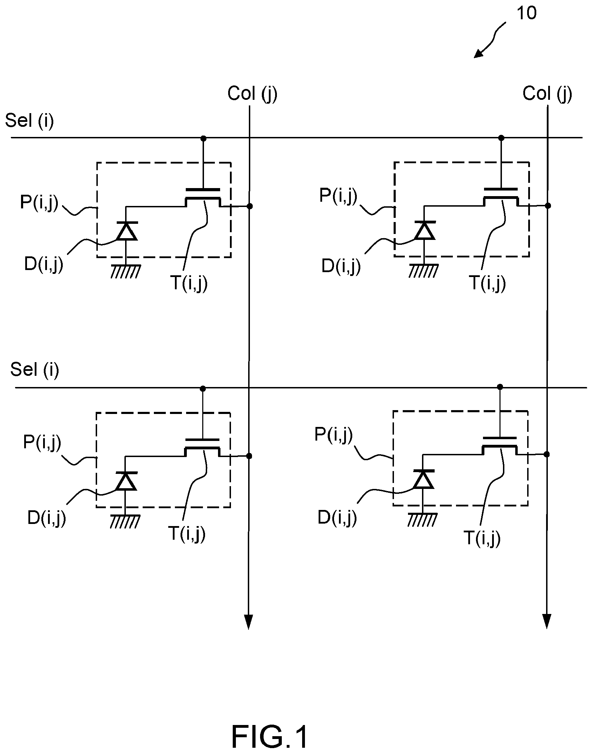

**La** **figure** 1 représente schématiquement une matrice 10 de deux lignes et deux colonnes pour simplifier la compréhension. Quatre pixels P sont formés, chacun à l'intersection d'une ligne et d'une colonne. Il est bien entendu que les matrices réelles sont généralement beaucoup plus grandes et possèdent un grand nombre de lignes et de colonnes. La matrice 10 appartient à un détecteur matriciel permettant de réaliser des images numérisées.

Chaque pixel P comprend une zone photosensible, représentée ici par une photodiode D, et un circuit électronique de traitement formé, dans l'exemple de la figure 1, par un seul transistor T. Les références des composants D et T sont suivies de de deux coordonnées (i,j) pouvant prendre le rang de la ligne pour i et le rang de la colonne pour j. Ce pixel est aussi appelé pixel de type 1T car possédant un transistor dont la fonction va être décrite plus loin.

De façon générale, il est connu de réaliser des matrices de pixels comprenant des transistors mettant en œuvre des semi-conducteurs complémentaires en silicium cristallin connus dans la littérature anglo-saxonne par leur abréviation CMOS pour : " Complementary Metal Oxide Semiconductor ". L'invention ne se limite pas à ce type de transistors, on peut par exemple la mettre en œuvre pour des matrices comprenant des transistors à effet de champ à couches minces connus dans la littérature anglo-saxonne sous le nom de TFT pour : " Thin-film transistor ". Les transistors de type TFT peuvent être à base d'oxydes métalliques comme par exemple les transistors à base d'oxyde amorphe ou cristallin d'indium, de gallium et de zinc connus sous leur abréviation anglo-saxonne : IGZO. D'autres familles de transistors de type TFT peuvent être mises en œuvre comme par exemple les TFT organiques, les TFT en silicium amorphe, les TFT en silicium polycristallin.

Les pixels P d'une même colonne sont raccordés à un conducteur de colonne Col. Ce conducteur permet le recueil d'informations provenant des pixels qui lui sont reliés. Les pixels P d'une même ligne sont raccordés à un conducteur de ligne Sel véhiculant un signal permettant de commander chacune des lignes de pixels.

Lors d'une phase de prise d'image, l'éclairement reçu par chacune des photodiodes D fait décroître le potentiel de sa cathode sur laquelle des charges s'accumulent en fonction de l'éclairement reçu. Cette phase de prise d'image est suivie d'une phase de lecture pendant laquelle le potentiel de la photodiode D est lu. Pour ce faire, on rend passant le transistor T, qui a donc un rôle d'interrupteur, grâce à une commande de sélection de ligne véhiculée par le conducteur Sel et appliquée à sa grille. Les différentes lignes de pixels sont lues séquentiellement. Les conducteurs de colonne Col sont utilisés séquentiellement pour le recueil d'information provenant des pixels des différentes colonnes lorsque celui-ci est sélectionné. La phase de lecture vide les charges de la photodiode D et permet sa remise à zéro avant une nouvelle phase de prise d'image.

Il est également possible de mettre en œuvre l'invention dans un détecteur dont les pixels sont plus simples, notamment en remplaçant le transistor T par une simple diode mise en conduction au moyen du signal de sélection de ligne.

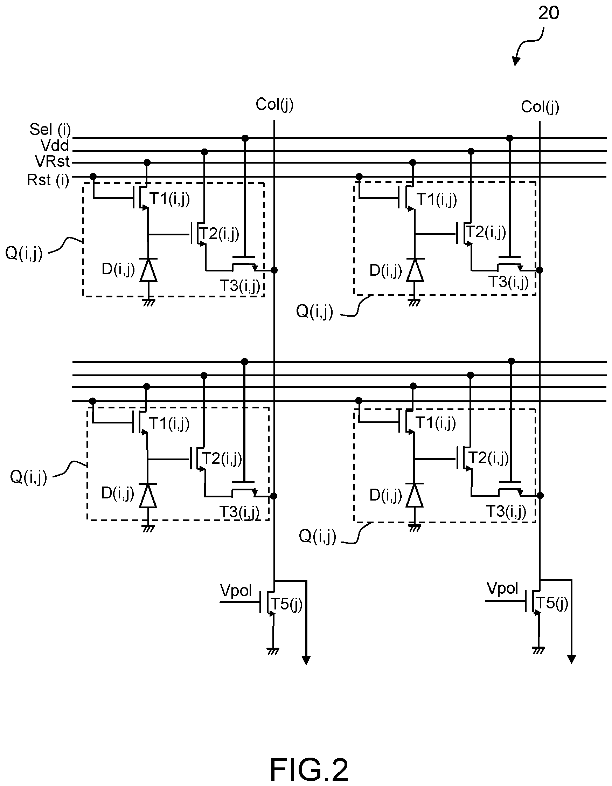

**La** **figure** 2 représente schématiquement un autre exemple de matrice 20 de pixels référencés Q et pouvant également être mis dans un détecteur d'image conforme à l'invention. Dans chaque pixel Q, on retrouve la photodiode D, et un circuit électronique de traitement formé ici de trois transistors T1, T2 et T3. Comme précédemment, les repères de la photodiode D et des trois transistors sont suivi de deux coordonnées (i,j) pouvant prendre le rang de la ligne pour i et le rang de la colonne pour j. Dans la pratique ce type de pixel peut comprendre d'autres composants, notamment d'autres transistors. C'est pourquoi ce pixel est aussi appelé pixel de type 3T, car possédant au moins trois transistors.

Les pixels Q d'une même colonne partagent un transistor T5 situés en extrémité du conducteur de colonne Col. Les pixels Q d'une même ligne sont raccordés à quatre conducteurs de ligne : Sel(i), Vdd, VRst et Rst(i) permettant de commander chacun des lignes de pixels.

Le transistor T1 permet de réinitialiser la tension de la cathode de la photodiode D, à une tension portée par le conducteur VRst. En première approche cette tension reste fixe et ne varie pas lors de phase de prise d'image et de lecture. La tension VRst est appliquée à la cathode de la diode D lors d'une opération de remise à zéro pendant laquelle un signal de commande porté par le conducteur Rst est actif.

Lors d'une phase de prise d'image, intervenant après une opération de remise à zéro, comme pour le pixel P, l'éclairement reçu par la photodiode D du pixel Q fait décroître le potentiel de sa cathode. Cette phase de prise d'image est suivie d'une phase de lecture pendant laquelle, on lit le potentiel de la photodiode D. Pour ce faire, on rend passant le transistor T3, qui a donc un rôle d'interrupteur, grâce à une commande de sélection du pixel, appliquée à sa grille et portée par le conducteur Sel. Le transistor T3 du pixel de type 3T remplit le même rôle fonctionnel que le transistor T d'un pixel de type 1T décrit à l'aide de la figure 1.

Le transistor T2 fonctionne en suiveur et est alimenté par une tension portée par le conducteur Vdd. Le transistor T5 fonctionne en source de courant. Les transistors T2 et T5 forment alors un étage suiveur de tension qui recopie la tension présente sur la cathode de la photodiode D, et la reproduit, à un décalage près, sur conducteur de colonne Col lorsque le transistor T3 est passant. Pour réaliser sa recopie, le transistor T2 nécessite un courant de polarisation circulant dans son drain et sa source. Ce courant est imposé par un générateur de courant formé par un transistor T5 commun ou non à plusieurs pixels. Dans l'exemple représenté, le transistor T5 est commun à une colonne de pixels. Il est aussi possible de n'utiliser qu'un seul transistor T5 source de courant, pour toute la matrice, à condition de le commuter successivement sur les différentes colonnes, au fur et à mesure de la lecture de ces mêmes colonnes. Le conducteur de colonne Col est utilisé à la fois pour la polarisation du transistor T2 et pour le recueil d'information provenant d'un pixel de la colonne correspondante lorsque celui-ci est sélectionné au moyen du signal Sel. Alternativement, il est possible de dédoubler le conducteur de colonne Col afin de séparer ses deux fonctions.

L'invention peut être mise en œuvre pour des pixels dont le fonctionnement est différent. A titre d'exemple l'invention peut être mise en œuvre pour des pixels de type 4T. En complément des transistors T1, T2 et T3, Les pixels 4T comprennent un transistor supplémentaire disposé entre la cathode de la photodiode D et la grille du transistor T2 formant le nœud du pixel. Ce transistor supplémentaire permet de transférer les charges accumulées dans la photodiode D vers le nœud du pixel à un instant choisi.

Dans l'exemple de **la** **figure 1****,** un conducteur de ligne et dans l'exemple de **la** **figure 2****,** plusieurs conducteurs de ligne sont raccordés aux différents pixels P ou Q d'une même ligne. Des circuits de commande, non représentés sur **les** **figures 1** **et** **2****,** généralement des registres à décalage, générant les signaux de commande portés par le conducteur Sel(i) et le conducteur Rst(i) lorsqu'il est mis en œuvre, sont raccordés aux conducteurs de ligne correspondants. Dans la variante de **la** **figure 2****,** des circuits d'alimentation, également non représentés et générant les tensions portées par les conducteurs Vdd et Vrst sont raccordés aux conducteurs de ligne correspondants. Les tensions des signaux portées par les conducteurs Vdd et Vrst sont constantes et peuvent être identiques auquel un seul type de conducteur de ligne peut être utilisé pour véhiculer les deux signaux et l'alimentation de ce type de conducteur est assurée par un même circuit d'alimentation. Ce type de conducteur commun est alors relié aux transistors T1 et T2 de chacun des pixels Q. Les conducteurs Vdd et Vrst sont également appelés conducteurs d'alimentation du fait de la constance de la tension qui leur est appliquée. Les circuits de commande et le cas échéant les circuits d'alimentation sont disposés en extrémité de ligne. Par ailleurs des circuits de lecture sont disposés en extrémité de chacun des conducteurs de colonne Col.

L'appellation ligne et colonne est purement arbitraire et pourrait être inversée. En pratique, les circuits de commande et les circuits d'alimentation peuvent être disposés sur un coté de la matrice et les circuits de lecture peuvent être disposés sur un coté de la matrice perpendiculaire au coté sur lequel sont situé les circuits de commande et les circuits d'alimentation. Afin de simplifier le raccordement des différents circuits, Il est également possible de disposer tous les circuits, de commande, d'alimentation et de lecture d'un même côté de la matrice.

Les circuits de lecture associés aux conducteurs de colonne Col permettent par exemple de numériser les signaux collectés sur les conducteurs de colonne. Les différents circuits de lecture peuvent comprendre un multiplexeur permettant d'assembler les signaux provenant de toute une ligne de pixels. Une fois que la lecture d'une ligne est réalisée par les circuits de lecture, il est possible de sélectionner une nouvelle ligne pour réitérer l'opération de lecture.

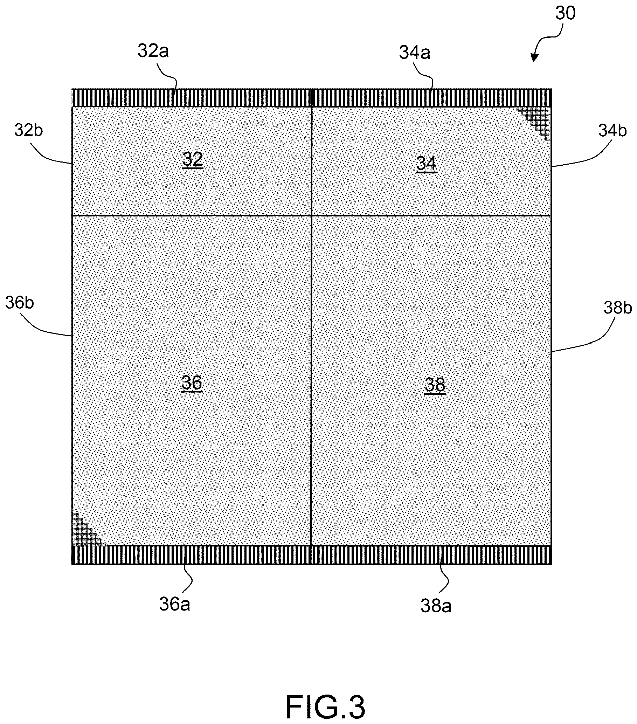

**La** **figure** 3 représente schématiquement un exemple de capteur 30 comprenant quatre capteurs élémentaires 32, 34, 36 et 38 formés chacun sur un substrat indépendant, respectivement 32b, 34b, 36b et 38b. les capteurs élémentaires et donc les substrats respectifs ont la même forme. Dans l'exemple représenté, les capteurs élémentaires 32, 34, 36 et 38 ont une forme rectangulaire et sont raboutés le long d'un côté. La forme rectangulaire est bien adaptée à une matrice de pixels où les lignes et les colonnes s'étendent perpendiculairement entre eux. Il est possible de mettre en œuvre l'invention pour d'autres formes polygonales de capteurs élémentaires. L'invention peut être mise en œuvre quel que soit le nombre de capteurs élémentaires. Chacun des capteurs élémentaires 32, 34, 36 et 38 comprend une matrice de pixel telle décrite à **la** **figure 1** ou à **la** **figure 2****.** Ces quatre capteurs élémentaires 32, 34, 36 et 38 sont raboutés pour former le capteur 30. Chaque capteur comprend des zones, respectivement 32a, 34a, 36a et 38a dans laquelle sont disposés les circuits de lecture et les transistors T5. Les zones 32a, 34a, 36a et 38a ne contiennent aucun pixel. Les zones 32a, 34a, 36a et 38a sont situées au niveau de l'extrémité libre des colonnes, c'est-à-dire l'extrémité n'étant pas au contact d'un autre capteur élémentaire. Au niveau du raboutage des capteurs élémentaires les pixels sont les plus proches possibles. Pour éviter toute rupture de l'image au niveau du raboutage, les pixels de capteurs élémentaires différents sont distants du même intervalle que le pas séparant deux pixels voisins d'un même capteur élémentaire. Les conducteurs des différents capteurs élémentaires ne sont pas connectés entre eux au niveau du raboutage. Autrement dit, il n'y a aucun conducteur reliant un capteur élémentaire à un autre au niveau du raboutage des capteurs élémentaires. Dans chacun des capteurs élémentaires 32, 34, 36 et 38, les conducteurs de rangée cheminent dans la matrice entre les pixels des différentes rangées. Plus précisément, les conducteurs Sel, Vdd, VRst et Rst cheminent dans leur capteur élémentaire respectif entre les lignes de pixels et les conducteurs Col cheminent, toujours dans leur capteur élémentaire respectif, entre les colonnes de pixels. Chacun des capteurs élémentaires 32, 34, 36 et 38 comprend des circuits de commande permettant de générer les signaux portés par ses propres conducteurs Sel et Rst. Chacun des capteurs élémentaires 32, 34, 36 et 38 comprend également des circuits d'alimentation permettant de générer les signaux portés par ses propres conducteurs Vdd et VRst. Les circuits de commande et les circuits d'alimentation peuvent être disposés en extrémité libre des lignes. Alternativement, ils peuvent être disposés dans les zones 32a, 34a, 36a et 38a. Les conducteurs Sel, Vdd, VRst et Rst sont alors disposés en colonne tout comme les conducteurs Col. Il en est de même pour les conducteurs de colonne permettant la lecture des pixels. Chaque capteur élémentaire comprend ses propres circuits de lecture. Les conducteurs colonne Col des différents capteurs élémentaires ne sont pas connectés entre eux, même s'ils sont dans le prolongement les uns des autres. Par la suite, on ne distinguera pas l'orientation des conducteurs, l'invention pouvant être mise en œuvre quel que soit cette orientation. Par contre on distinguera les différents types de conducteurs.

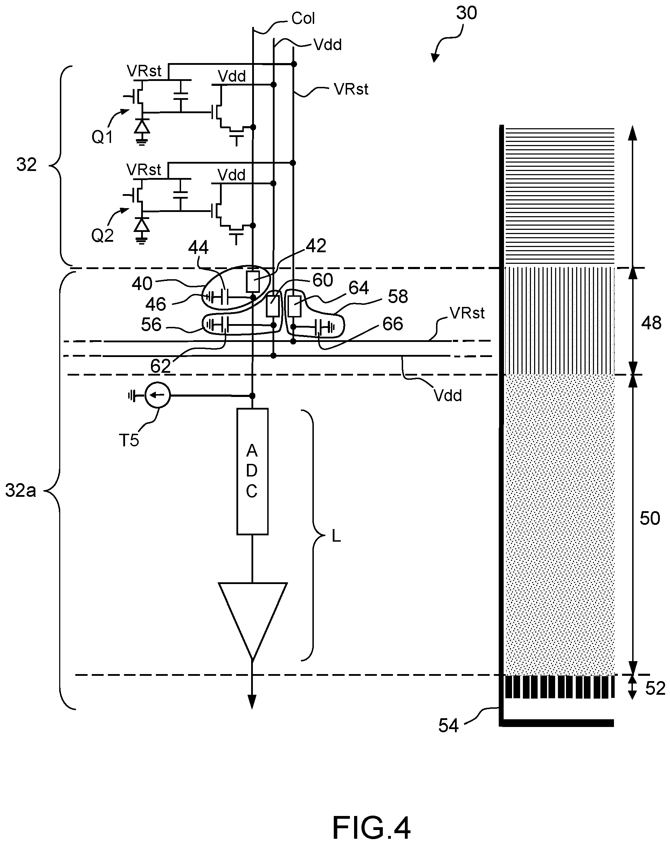

**La** **figure 4** représente plus en détail une partie d'un des capteurs élémentaires et plus précisément le capteur élémentaire 32 et sa zone 32a. Ce détail s'applique à tous les capteurs élémentaires. Dans la partie représentée, apparait deux pixels Q1 et Q2 raccordés à un même conducteur de colonne Col. Il est aisé de transposer le schéma représenté sur **la** **figure 4** pour un capteur mettant en œuvre un pixel P de type 1T. Dans la zone 32a on retrouve la source de courant représentée par le transistor T5 et un circuit de lecture L comprenant par exemple un convertisseur analogique numérique ADC permettant de numériser la tension présente sur le conducteur Col lors des différentes opérations de lectures des différentes lignes de la matrice de pixels Q.

Sur **la** **figure 4****,** apparait, raccordé au conducteur de colonne Col, un groupe de composants 40, distinct du conducteur Col et formant une impédance d'adaptation du conducteur Col. Le capteur 30 comprend pour chacun de ses conducteurs colonne Col un groupe de composants formant une impédance d'adaptation du conducteur considéré.

A l'intérieur d'un même capteur élémentaire 32, 34, 36 ou 38, les impédances raccordées aux différents conducteurs colonne Col ont une même valeur. D'un capteur élémentaire à l'autre, les impédances ont des valeurs différentes de façon à équilibrer les impédances de liaison entre les différents circuits de lecture et les conducteurs de colonne Col correspondants pour les différents capteurs élémentaires.

Sur **la** **figure 4****,** le groupe de composants 40 comprend une résistance 42 et un condensateur 44. La résistance 42 est raccordée en série entre le circuit de lecture L et le pixel Q2 qui est le plus proche du circuit de lecture L. Le condensateur 44 est raccordé entre une des bornes de la résistance 42 et une masse 46 du capteur 30. Ce circuit RC est donné à tire d'exemple. Le groupe de composants peut ne comprendre qu'une résistance sans condensateur. Autrement dit, le groupe de composants 40 peut ne comporter qu'un seul composant. On peut également ajouter au groupe 40 une inductance en fonction du besoin d'adaptation d'impédance.

Le choix du type de composants et leur dimensionnement permet de compenser les effets des différences de longueur des conducteurs entre les différents capteurs élémentaires 32, 34, 36 et 38. La résistance 42 permet de compenser les différences de résistance des conducteurs. Le condensateur 44 et éventuellement l'inductance associée permettent de compenser des différences pouvant intervenir dans le temps d'établissement du signal pendant la phase de lecture entre l'instant où le transistor T3 d'un pixel devient passant et l'instant où le circuit de lecture L reçoit ce signal.

Les composants du groupe 40 peuvent être réalisés directement sur le substrat du capteur élémentaire auquel ils sont associés dans une première partie 48 de la zone 32a. Il en est de même pour le circuit de lecture L qui peut être réalisé également dans une deuxième partie 50 de la zone 32a. En aval du circuit de lecture L, le capteur élémentaire peut comprendre une troisième partie 52 de la zone 32a permettant le raccordement du capteur 30 vers son environnement. Entourant la partie 52, le capteur 30 peut comprendre un joint de scellement 54 assurant l'étanchéité de l'ensemble des composants présents sur les substrats après raboutage. Le joint de joint de scellement 54 est réalisé entre une fenêtre d'entrée, non représentée et les différents substrats des capteurs élémentaires 32 à 38. Les éléments photosensibles peuvent être directement sensibles au rayonnement auquel le capteur 30 est sensible. Dans le domaine des rayons X, il est courant de disposer un scintillateur entre la fenêtre d'entrée et les capteurs élémentaires 32 à 38. Le scintillateur reçoit les photons X et réémet des photons de plus basse énergie dans une bande de longueur d'onde auquel les éléments photosensibles sont sensibles. Le scintillateur recouvre les zones où sont présents les pixels. Les parties 48 et 50 peuvent être utilisées comme zone de tolérance de positionnement du scintillateur.

Indépendamment du groupe de composants 40 associé au conducteur de colonne Col, le capteur 30 peut comprendre associé au conducteur d'alimentation Vdd et/ou au conducteur d'alimentation VRst, un autre groupe de composant, respectivement 56 et 58. Comme pour le groupe de composants 40, les groupes de composants 56 et 58 sont distincts du conducteur auquel ils sont associés, Vdd ou VRst et forment une impédance d'adaptation du conducteur d'alimentation respectif. Dans l'exemple représenté sur **la** **figure 4****,** le groupe de composants 56 comprend une résistance 60 et un condensateur 62. Le groupe de composants 58 comprend une résistance 64 et un condensateur 66. Les groupes de composants 56 et 58 sont raccordés à leur conducteurs respectifs Vdd et VRst de la même façon que le groupe de composants 40 au conducteur de colonne Col.

Concernant le conducteur d'alimentation VRst, lors de la remise à zéro des pixels au moyen de la commande portée par le conducteur de commande Rst, les photodiodes D des différents pixels vont se décharger par le conducteur VRst et donc entrainer une chute de tension sur ce conducteur. Les différences de longueur de ces conducteurs en fonction du capteur élémentaire sur lequel il se situe entrainent des chutes de tension différentes. Par conséquent, les décharges des différentes photodiodes D ne seront pas identiques entrainant des écarts d'offset entre les différents pixels. Il est possible de corriger ces écarts en adaptant la valeur des différentes résistances 64 en fonction du capteur élémentaire sur lequel se situe le conducteur VRst associé. De plus, la remise à zéro des pixels génère un appel de courant sur le conducteur VRst entrainant des chutes de tension momentanées dont la durée varie en fonction de la longueur du conducteur VRst. A la suite de cet appel de courant, le conducteur revient à l'équilibre. La durée de ce retour à l'équilibre dépend également de la longueur du conducteur VRst. Il est possible d'équilibrer ces durées en adaptant la valeur du condensateur 66 et éventuellement d'une inductance associée.

Concernant le conducteur d'alimentation Vdd, alimentant les transistors T2 des différents pixels, afin de recopier le plus fidèlement possible la tension présente sur la cathode de la photodiode D, il est nécessaire d'équilibrer au mieux les tensions présentes sur ce conducteur en fonction des différents capteurs élémentaires. Une différence de tension sur le conducteur Vdd peut présenter ses effets les plus notables au voisinage du raboutage des différents capteurs élémentaires pouvant entrainer une différence visible dans l'image pour des pixels voisins appartenant à des capteurs élémentaires différents. L'équilibrage des tensions des différents conducteurs Vdd pour limiter les effets de seuil au niveau du raboutage se fait aussi bien au moyen des résistances 60 pour la valeur moyenne des tensions que des condensateurs 62 et éventuellement des inductances associées pour les temps d'établissement de ces tensions.

Il est également possible de prévoir l'équilibrage des impédances des conducteurs de commande Sel et Rst. Comme précédemment décrit, l'équilibrage de ces impédances se fait au moyen de groupes de composants raccordés aux conducteurs correspondants et disposés entre les matrices de pixels et les circuits de commande associés. Pour ne pas surcharger **la** **figure 4****,** ces groupes de composants ne sont pas représentés. Ils peuvent également être disposés dans la partie 48 de chacun des capteurs élémentaires.

Les différents composants des groupes 40, 56 et 50 peuvent être réalisés au moyen de dépôt de couches métalliques sur les substrats des capteurs élémentaires concernés. D'autres méthodes de fabrications permettent d'obtenir notamment des résistances comme par exemples l'utilisation de zones dopées à l'inverse du dopage du substrat. Cette méthode conduit à réaliser des résistances connues dans la littérature anglo-saxonne sous le nom de « well resistor ». Les condensateurs peuvent être réalisés comme un transistor dont le drain et la source sont court-circuités.

## Revendications

1. Capteur photosensible comprenant plusieurs capteurs élémentaires raboutés (32, 34, 36, 38), chaque capteur élémentaire comprenant une matrice de pixels (P ; Q) organisés en rangées, les pixels de chaque rangée étant reliés à des conducteurs de plusieurs types (Col, Sel, Vdd, VRst, Rst), dont des conducteurs de colonne (Col) reliés à des circuits de lecture (L) du capteur, **caractérisé en ce qu'**il comprend, raccordé à chacun des conducteurs de colonne (Col), un groupe de composants (40) distinct du conducteur considéré, le groupe de composants (40) formant une impédance d'adaptation du conducteur (Col) considéré, **en ce que** dans chaque capteur élémentaire (32, 34, 36, 38), les impédances ont une même valeur et **en ce que** pour des capteurs élémentaires différents, les impédances ont des valeurs d'impédance différentes de façon à équilibrer les impédances de liaison entre les différents circuits de lecture (L) et les conducteurs de colonne (Col) correspondants pour les différents capteurs élémentaires.

2. Capteur photosensible selon la revendication 1, **caractérisé en ce que** les pixels (P ; Q) de chaque rangée sont reliés à des conducteurs de type conducteur d'alimentation (VRst, Vdd) reliés à des circuits d'alimentation du capteur, **en ce qu'**il comprend, raccordé à chacun des conducteurs d'alimentation, un groupe de composants (56, 58) distinct du conducteur considéré, le groupe de composants formant une impédance d'adaptation du conducteur considéré, **en ce que** dans chaque capteur élémentaire, les impédances ont une même valeur et **en ce que** dans des capteurs élémentaires différents, les impédances ont des valeurs d'impédance différentes de façon à équilibrer les impédances de liaison entre les différents circuits d'alimentation et les conducteurs d'alimentation correspondants pour les différents capteurs élémentaires.

3. Capteur photosensible selon l'une des revendications précédentes, **caractérisé en ce que** les pixels (P ; Q) de chaque rangée sont reliés à des conducteurs de type conducteur de commande (Sel, Rst) reliés à des circuits de commande du capteur, **en ce qu'**il comprend, raccordé à chacun des conducteurs de commande, un groupe de composants distinct du conducteur (Sel, Rst) considéré, le groupe de composants formant une impédance d'adaptation du conducteur considéré, **en ce que** dans chaque capteur élémentaire (32, 34, 36, 38), les impédances ont une même valeur et **en ce que** dans des capteurs élémentaires différents, les impédances ont des valeurs d'impédance différentes de façon à équilibrer les impédances de liaison entre les différents circuits de commande et les conducteurs de commande correspondants pour les différents capteurs élémentaires.

4. Capteur photosensible selon l'une des revendications précédentes, **caractérisé en ce que** pour deux capteurs élémentaires (32, 34, 36, 38) distincts, les conducteurs d'au moins un type (Col, Sel, Vdd, VRst, Rst) possèdent des longueurs différentes et **en ce que** les valeurs d'impédances des groupes de composants (40, 56, 58) associés aux conducteurs d'au moins un type sont adaptées en fonction de leur longueur respective.

5. Capteur photosensible selon l'une des revendications précédentes, **caractérisé en ce que** les groupes de composants (40, 56, 58) comprennent une résistance (42, 60, 64) raccordée en série sur le conducteur considéré (Col, Sel, Vdd, VRst, Rst) et une capacité (44, 62, 66) raccordée entre le conducteur considéré et une masse du dispositif (46).

6. Capteur photosensible selon l'une des revendications précédentes, **caractérisé en ce que** chaque groupe de composants (40, 56, 58) est disposé sur un substrat du capteur élémentaire (32, 34, 36, 38) correspondant entre la matrice de pixels et le circuit auquel le conducteur (Col, Sel, Vdd, VRst, Rst) associé est raccordé.

7. Capteur photosensible selon l'une des revendications précédentes, **caractérisé en ce que** les capteurs élémentaires (32, 34, 36, 38) sont formés chacun sur un substrat indépendant (32b, 34b, 36b, 38b).

## Patentansprüche

1. Lichtempfindlicher Sensor, umfassend mehrere zusammengefügte Elementarsensoren (32, 34, 36, 38), wobei jeder Elementarsensor eine Matrix aus Pixeln (P;Q) umfasst, welche in Reihen organisiert sind, wobei die Pixel einer jeden Reihe mit mehreren Arten von Leitern (Col, Sel, Vdd, VRst, Rst) verbunden sind, darunter Spaltenleiter (Col), welche mit Leseschaltungen (L) des Sensors verbunden sind, **dadurch gekennzeichnet, dass** er, verbunden mit jedem der Spaltenleiter (Col), eine Gruppe von Komponenten (40) umfasst, die sich von dem betrachteten Leiter unterscheidet, wobei die Gruppe von Komponenten (40) eine Anpassungsimpedanz des betrachteten Leiters (Col) bildet, dadurch, dass, in jedem Elementarsensor (32, 34, 36, 38), die Impedanzen einen gleichen Wert aufweisen und dadurch, dass, bei unterschiedlichen Elementarsensoren, die Impedanzen unterschiedliche Impedanzwerte aufweisen, um die Verbindungsimpedanzen zwischen den unterschiedlichen Leseschaltungen (L) und den entsprechenden Spaltenleitern (Col) für die unterschiedlichen Elementarsensoren auszugleichen.

2. Lichtempfindlicher Sensor nach Anspruch 1, **dadurch gekennzeichnet, dass** die Pixel (P;Q) einer jeden Reihe mit Leitern vom Typ Speisungsleiter (VRst, Vdd) verbunden sind, welche mit Schaltungen zum Speisen des Sensors verbunden sind, **dadurch gekennzeichnet, dass** der lichtempfindliche Sensor, verbunden mit jedem der Speisungsleiter, eine Gruppe von Komponenten (56, 58) umfasst, die sich von dem betrachteten Leiter unterscheidet, wobei die Gruppe von Komponenten eine Anpassungsimpedanz des betrachteten Leiters bildet, dadurch, dass, in jedem Elementarsensor, die Impedanzen einen gleichen Wert aufweisen und dadurch, dass, in unterschiedlichen Elementarsensoren, die Impedanzen unterschiedliche Impedanzwerte aufweisen, um die Verbindungsimpedanzen zwischen den unterschiedlichen Speisungsschaltungen und den entsprechenden Speisungsleitern für die unterschiedlichen Elementarsensoren auszugleichen.

3. Lichtempfindlicher Sensor nach einem der vorhergehenden Ansprüche, **dadurch gekennzeichnet, dass** die Pixel (P;Q) einer jeden Reihe mit Leitern vom Typ Steuerungsleiter (Sel, Rst) verbunden sind, welche mit Schaltungen zum Steuern des Sensors verbunden sind, dadurch, dass der lichtempfindliche Sensor, verbunden mit jedem der Steuerungsleiter, eine Gruppe von Komponenten umfasst, die sich von dem betrachteten Leiter (Sel, Rst) unterscheidet, wobei die Gruppe von Komponenten eine Anpassungsimpedanz des betrachteten Leiters bildet, dadurch, dass, in jedem Elementarsensor (32, 34, 36, 38), die Impedanzen einen gleichen Wert aufweisen und dadurch, dass, in unterschiedlichen Elementarsensoren, die Impedanzen unterschiedliche Impedanzwerte aufweisen, um die Verbindungsimpedanzen zwischen den unterschiedlichen Steuerungsschaltungen und den entsprechenden Steuerungsleitern für die unterschiedlichen Elementarsensoren auszugleichen.

4. Lichtempfindlicher Sensor nach einem der vorhergehenden Ansprüche, **dadurch gekennzeichnet, dass** bei zwei unterschiedlichen Elementarsensoren (32, 34, 36, 38) die Leiter mindestens einer Art (Col, Sel, Vdd, VRst, Rst) unterschiedliche Längen aufweisen, und dadurch, dass die Impedanzwerte der Gruppe von Komponenten (40, 56, 58), welche den Leitern mindestens einer Art zugeordnet sind, entsprechend ihrer jeweiligen Länge angepasst sind.

5. Lichtempfindlicher Sensor nach einem der vorhergehenden Ansprüche, **dadurch gekennzeichnet, dass** die Gruppen von Komponenten (40, 56, 58) einen Widerstand (42, 60, 64) umfassen, welcher in Reihe an den betrachteten Leiter (Col, Sel, Vdd, VRst, Rst) angeschlossen ist, und eine Kapazität (44, 62, 66), welche zwischen dem betrachteten Leiter und der Masse der Vorrichtung (46) angeschlossen ist.

6. Lichtempfindlicher Sensor nach einem der vorhergehenden Ansprüche, **dadurch gekennzeichnet, dass** jede Gruppe von Komponenten (40, 56, 58) an einem Substrat des entsprechenden Elementarsensors (32, 34, 36, 38) zwischen der Pixelmatrix und der Schaltung angeordnet ist, an welcher der zugeordnete Leiter (Col, Sel, Vdd, VRst, Rst) angeschlossen ist.

7. Lichtempfindlicher Sensor nach einem der vorhergehenden Ansprüche, **dadurch gekennzeichnet, dass** die Elementarsensoren (32, 34, 36, 38) jeweils an einem unabhängigen Substrat (32b, 34b, 36b, 38b) gebildet sind.

## Claims

1. A photosensitive sensor comprising multiple elementary sensors butted together (32, 34, 36, 38), each elementary sensor comprising a matrix of pixels (P;Q) organized in rows, the pixels of each row being connected to conductors of multiple types (Col, Sel, Vdd, VRst, Rst), including column conductors (Col) which are connected to read circuits (L) of the sensor, **characterised in that** it comprises, connected to each of the column conductors (Col), a group of components (40) that is separate from the conductor under consideration, the group of components (40) forming a matching impedance of the conductor (Col) under consideration, **in that** in each elementary sensor (32, 34, 36, 38), the impedances have the same value and **in that** the impedances have different impedance values for different elementary sensors so as to balance the link impedances between the various read circuits (L) and the corresponding column conductors (Col) for the various elementary sensors.

2. The photosensitive sensor according to claim 1, **characterised in that** the pixels (P;Q) of each row are connected to conductors of power supply conductor type (VRst, Vdd) that are connected to circuits for supplying power to the sensor, **in that** the photosensitive sensor comprises, connected to each of the power supply conductors, a group of components (56, 58) that is separate from the conductor under consideration, the group of components forming a matching impedance of the conductor under consideration, **in that**, in each elementary sensor, the impedances have the same value and **in that** in different elementary sensors the impedances have different impedance values so as to balance the link impedances between the various power supply circuits and the corresponding power supply conductors for the various elementary sensors.

3. The photosensitive sensor according to any of the preceding claims, **characterised in that** the pixels (P;Q) of each row are connected to conductors of control conductor type (Sel, Rst) that are connected to circuits for controlling the sensor, **in that** the photosensitive sensor comprises, connected to each of the control conductors, a group of components that is separate from the conductor (Sel, Rst) under consideration, the group of components forming a matching impedance of the conductor under consideration, **in that**, in each elementary sensor (32, 34, 36, 38), the impedances have the same value and **in that**, in different elementary sensors, the impedances have different impedance values so as to balance the link impedances between the various control circuits and the corresponding control conductors for the various elementary sensors.

4. The photosensitive sensor according to any of the preceding claims, **characterised in that** for two separate elementary sensors (32, 34, 36, 38) the conductors of at least one type (Col, Sel, Vdd, VRst, Rst) have different lengths and wherein the impedance values of the groups of components (40, 56, 58) associated with the conductors of at least one type are matched according to their respective length.

5. The photosensitive sensor according to any of the preceding claims, **characterised in that** the groups of components (40, 56, 58) comprises a resistor (42, 60, 64) connected in series on the conductor under consideration (Col, Sel, Vdd, VRst, Rst), and a capacitance (44, 62, 66) connected between the conductor under consideration and the earth of the device (46).

6. The photosensitive sensor according to any of the preceding claims, **characterised in that** each group of components (40, 56, 58) is arranged on a substrate of the corresponding elementary sensor (32, 34, 36, 38) between the pixel matrix and the circuit to which the associated conductor (Col, Sel, Vdd, VRst, Rst) is connected.

7. The photosensitive sensor according to any of the preceding claims, **characterised in that** the elementary sensors (32, 34, 36, 38) are each formed on an independent substrate (32b, 34b, 36b, 38b).
